**Europäisches Patentamt**

**European Patent Office**

**Office européen des brevets**

(19)

(11) Numéro de publication : **0 445 045 A1**

(12) # DEMANDE DE BREVET EUROPEEN

(21) Numéro de dépôt : **91420015.9**

(22) Date de dépôt : **22.01.91**

(51) Int. Cl.$^5$ : **G06F 13/40**

(30) Priorité : **26.01.90 FR 9001100**

(43) Date de publication de la demande :
**04.09.91 Bulletin 91/36**

(84) Etats contractants désignés :
**DE FR GB IT**

(71) Demandeur : **SGS-THOMSON MICROELECTRONICS S.A.**
**7, Avenue Galliéni**
**F-94250 Gentilly (FR)**

(72) Inventeur : **Ramet, Serge**
**23, Rue Commandant Perreau**
**F-38100 Grenoble (FR)**

(74) Mandataire : **de Beaumont, Michel**
**1bis, rue Champollion**
**F-38000 Grenoble (FR)**

(54) **Procédé et circuit de commande d'un bus de sortie de circuit intégré.**

(57) La présente invention concerne un procédé de commande d'un bus à N conducteurs en sortie d'un circuit intégré, au rythme d'une horloge de commande (CLK), consistant à fournir les N données sur N étages de mémorisation intermédiaire pendant une première durée inférieure à la période d'horloge, et à transmettre chaque donnée à un étage amplificateur de sortie (I0 à I(N-1)) avec un décalage temporel (t) déterminé par rapport à la donnée de rang adjacent, chaque décalage temporel étant supérieur à la durée de commutation d'un étage de sortie, et la somme des N-1 des décalages temporels étant inférieure à ladite première durée.

Figure 2

EP 0 445 045 A1

# PROCEDE ET CIRCUIT DE COMMANDE D'UN BUS DE SORTIE DE CIRCUIT INTEGRE

La présente invention concerne la commande de sorties numériques sur un circuit intégré.

Dans un circuit intégré contenant une partie numérique et une partie analogique sensible, la commutation des étages amplificateurs de sortie (buffers) d'un bus de sortie numérique peut, par l'appel de courant qu'elle provoque, perturber notablement la partie analogique.

Dans l'art antérieur, pour pallier cet inconvénient, on a prévu des circuits dans lesquels les plots d'alimentation des parties analogique et numérique sont séparés pour éviter les couplages par les lignes d'alimentation. Cependant, si tous les amplificateurs de sortie commutent simultanément, ceci produit un appel de courant qui, par suite du couplage par le substrat commun aux parties analogique et numérique, est susceptible de perturber la partie analogique notamment dans le cas où celle-ci contient des éléments mettant en jeu des signaux de très faible niveau, ce qui est le cas par exemple dans des convertisseurs analogique/numérique à haute résolution ou dans des amplificateurs à fort gain, auquel cas les perturbations transmises par le substrat ne sont pas négligeables devant les signaux analogiques utiles.

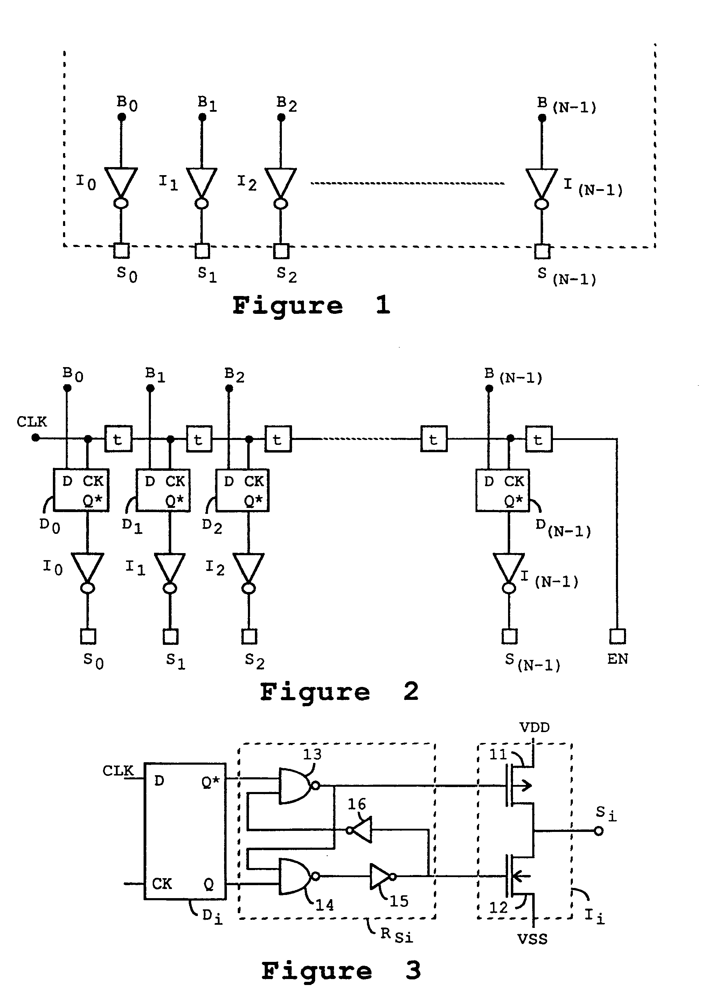

La figure 1 représente schématiquement l'étage de sortie d'un bus numérique de circuit intégré. N signaux numériques B0, B1, B2 ... B(N-1) sont fournis simultanément aux bornes d'un circuit de mémorisation intermédiaire, tel qu'un registre. Lors de la commutation de chacun des signaux B0 à B(N-1), qui se modifient simultanément au rythme d'une horloge, les amplificateurs de sortie I0, I1, I2 ... I(N-1), représentés ici sous forme d'inverseurs, commutent pour fournir des signaux amplifiés sur les bornes de sortie du bus S0, S1, S2 ... S(N-1) qui correspondent à des plots du circuit intégré.

Il est couramment admis qu'un circuit amplificateur tel qu'un inverseur fabriqué en technologie CMOS consomme très peu. Cela est exact, mais il faut tenir compte du fait qu'au moment d'une commutation entre un niveau bas et un niveau haut, un tel inverseur produit pendant une durée brève un appel de courant important, dont la valeur crête peut par exemple être de l'ordre de 125 milliampères pendant une durée de 4 ns. Si le bus contient 16 conducteurs, on peut arriver à des impulsions de courant d'une valeur crête de 4 ampères, ce qui est bien évidemment susceptible de perturber des circuits analogiques sensibles disposés sur le même substrat.

Ainsi, un objet de la présente invention est de résoudre ce problème et de réduire la consommation instantanée des amplificateurs de sortie lors de leur commutation pour permettre la fabrication de circuits comprenant des amplificateurs de sorties numériques et des circuits analogiques sensibles sur une même puce.

Pour atteindre cet objet, la présente invention, plutôt que d'isoler les parties numériques et analogiques ou de chercher à réduire la consommation instantanée de chaque amplificateur de signal numérique, vise à répartir dans le temps les surintensités des divers amplificateurs constituant l'étage de sortie du bus numérique.

Plus particulièrement, la présente invention prévoit un procédé de commande d'un bus à N conducteurs en sortie d'un circuit intégré, au rythme d'une horloge de commande consistant à fournir les N données sur N étages de mémorisation intermédiaire pendant une première durée inférieure à la période d'horloge, et à transmettre chaque donnée à un étage amplificateur de sortie avec un décalage temporel déterminé par rapport à la donnée de rang adjacent, chaque décalage temporel étant supérieur à la durée de commutation d'un étage de sortie, et la somme des N-1 décalages temporels étant inférieure à ladite première durée.

La présente invention prévoit également un circuit pour la mise en oeuvre de ce procédé. Ce circuit comprend, pour la commande de l'étage de sortie d'un bus numérique à N conducteurs, sur un circuit intégré, au rythme d'une horloge de commande, N étages amplificateurs de sortie ; une bascule D à l'entrée de chaque amplificateur, la sortie de cette bascule étant connectée à l'entrée d'un amplificateur, l'entrée D de chaque bascule recevant la donnée correspondante ; et un moyen de retard connecté entre les entrées d'horloge de deux bascules de rang adjacent, de sorte que la première bascule reçoit sur son entrée d'horloge un signal d'horloge et la dernière bascule reçoit ce signal d'horloge décalé de N-1 durées des moyens de retard ; la durée de chaque moyen de retard étant supérieure à la durée de commutation d'un étage de sortie, et la somme des N-1 durées de retard étant inférieure à la période d'horloge.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1, décrite précedemment, représente schématiquement l'étage de sortie d'un bus numérique classique ;

la figure 2 représente un mode de réalisation d'étage de sortie de bus numérique selon la présente invention ; et

la figure 3 représente un détail de réalisation du circuit de la figure 2.

Dans la figure 2, les parties communes au circuit déjà illustré en figure 1 sont désignées par les mêmes références, en particulier les données B0 à B(N-1), les inverseurs I0 à I(N-1) et les sorties S0 à S(N-1). Les données B0 à B(N-1) sont simultanément disponibles à la sortie d'un étage de mémorisation intermédiaire ou registre non représenté et doivent être transmises aux sorties S0 à S(N-1) au rythme d'une horloge CLK.

Selon la présente invention, chacune des données B0 à B(N-1) est transmise à l'inverseur correspondant I0 à I(N-1) avec un certain retard produit par un circuit de retard t. Dans ce but, chacune des données B0 à B(N-1) est envoyée à l'entrée D d'une bascule de type D, D0 à D(N-1), dont la sortie Q* est envoyée à un inverseur I0 à I(N-1). Le signal CLK est directement appliqué à l'entrée d'horloge CK de la bascule D0. Un premier moyen de retard t est inséré entre le signal d'horloge CLK et l'entrée CK de la bascule D1 ; un deuxième moyen de retard t est en série avec le premier moyen de retard t pour retarder de 2t l'application du signal d'horloge CLK vers l'entrée CK de la bascule D2, et ainsi de suite, de sorte que l'application du signal d'horloge CLK à l'entrée CK de la bascule D(N-1) est retardée de (N-1)t.

Les données étant décalées au rythme de l'horloge CLK et étant susceptibles de changer à ce rythme, il convient que la durée des N retards t soit inférieure à une période d'horloge, par exemple de l'ordre dela demi-période d'horloge pour tenir compte du temps de renouvellement des données elles-mêmes. En outre, chaque intervalle de temps t doit être choisi supérieur au temps de transition d'un inverseur I, indiqué précédemment à titre d'exemple comme étant de l'ordre de 4 ns.

Pour une bonne utilisation des données à l'autre extrémité du bus qui doit être reliée aux sorties S0 à S(N-1), on peut envoyer une impulsion de validation EN indiquant que toutes les sorties S0 à S(N-1) ont été mises à jour. Comme cela est indiqué en figure 2, cette impulsion de validation EN peut correspondre au signal retardé de N intervalles de retard t.

Le circuit décrit précédemment est particulièrement simple à réaliser. En effet, étant donné la brève durée des retards t, chacun des moyens de retard peut par exemple comprendre une paire d'inverseurs en série, les dimensions de canal des transistor MOS constituant l'un au moins de ces inverseurs étant choisies pour obtenir la valeur de retard souhaitée.

Bien entendu, la présente invention est susceptible de nombreuses variantes et modifications qui apparaîtront à l'homme de l'art. En particulier, on pourra adjoindre au circuit selon la présente invention, diverses variantes de réalisation connues en elles-mêmes.

Par exemple, la figure 3 illustre le fait que l'on peut insérer entre chacune des bascules Di et chacun des inverseurs Ii un circuit fournissant deux signaux d'horloge complémentaires à phases non-recouvrantes constitué d'une bascule RS, RSi.

L'inverseur Ii est classiquement constitué d'un transistor MOS à canal P 11 en série avec un transistor MOS à canal N 12 entre une alimentation haute VDD et une alimentation basse VSS, la sortie Si étant prise au point de raccordement de ces deux transistors. La bascule RS peut être constituée de deux portes NON ET 13 et 14, la porte ET 13 recevant sur sa première entrée la sortie Q* de la bascule de type D, Di, et la porte ET 14 la sortie Q de cette bascule. La deuxième entrée de la porte ET 14 reçoit la sortie de la porte ET 13 et la deuxième entrée de la porte ET 13 reçoit la sortie de la porte ET 14 par l'intermédiaire de deux inverseurs en série 15 et 16. La sortie de la porte ET 13 commande la grille du transistor MOS à canal P 11 et le point de raccordement des inverseurs 15 et 16 commande la grille du transistor MOS à canal N 12. Comme cela est connu, on obtient ainsi des signaux de commande de grille pour les transistors MOS 11 et 12 qui sont des signaux à la même fréquence que les signaux aux sorties Q et Q* de la bascule Di, c'est-à-dire à la fréquence du signal d'horloge CLK, mais ces signaux sont à phases non-recouvrantes, c'est-à-dire qu'il existe un temps mort entre les phases où chacun de ces signaux est positif.

## Revendications

1. Procédé de commande d'un bus à N conducteurs en sortie d'un circuit intégré, au rythme d'une horloge de commande (CLK), caractérisé en ce qu'il consiste à :

    fournir les N données sur N étages de mémorisation intermédiaire pendant une première durée inférieure à la période d'horloge, et

    transmettre chaque donnée à un étage amplificateur de sortie avec un décalage temporel déterminé par rapport à la donnée de rang adjacent, chaque décalage temporel étant supérieur à la durée de commutation d'un étage de sortie, et la somme des N-1 décalages temporels étant inférieure à ladite première durée.

2. Circuit de commande de l'étage de sortie d'un bus numérique à N conducteurs, sur un circuit intégré, au rythme d'une horloge de commande (CLK), comprenant N étages amplificateurs de sortie (I0 à I(N-1)), caractérisé en ce qu'il comprend :

    – une bascule D (D0 à D(N-1)) à l'entrée de chaque amplificateur, la sortie de cette bascule étant connectée à l'entrée d'un amplificateur, l'entrée D de chaque bascule recevant la donnée correspondante, et

    – un moyen de retard (t) connecté entre les entrées d'horloge (CK) de deux bascules de rang adjacent, de sorte que la première bascule (D0) reçoit sur son entrée d'horloge un signal d'horloge CLK et la dernière bascule reçoit ce signal d'horloge décalé de N-1 durées des moyens de retard,

la durée de chaque moyen de retard étant supérieure à la durée de commutation d'un étage de sortie, et la somme des N-1 durées de retard étant inférieure à la période d'horloge.

3. Circuit selon la revendication 2, caractérisé en ce que chaque moyen de retard est constitué de deux inverseurs en série, l'un au moins de ces inverseurs étant prévu pour fournir une durée de retard prédéterminée.

4. Circuit selon la revendication 2, caractérisé en ce que les étages de sortie sont des inverseurs et en ce que la sortie de chaque bascule D est fournie pour commander l'inverseur correspondant par l'intermédiaire d'un circuit (RSi) de génération de signaux de commande complémentaires à phases non-recouvrantes.

5. Circuit selon la revendication 2, caractérisé en ce qu'il comprend en outre un Nième moyen de retard en série avec les précédents pour fournir un signal de validation des sorties (EN).

**Figure 1**

**Figure 2**

**Figure 3**

Office européen
des brevets

**RAPPORT DE RECHERCHE EUROPEENNE**

Numero de la demande

EP 91 42 0015

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 307 793 (HONEYWELL BULL) * Abrégé; colonne 4, ligne 36 - colonne 7, ligne 8; figure 3 * | 1,2,5 | G 06 F 13/40 |
| A | WO-A-8 704 827 (DIGITAL EQUIPMENT CORP.) * Abrégé; page 12, ligne 20 - page 16, ligne 5; figures 6,7 * | 1,2 | |
| A | IBM TECHNICAL DISCLOSURE BULLETIN, vol. 23, no. 12, mai 1981, page 5488, New York, US; R.S. CAPOWSKI: "Low-noise bus with staggered clock times" * Article entier * | 1 | |
| A | RESEARCH DISCLOSURE, no. 296, décembre 1988, page 990, New York, US; "Disable-before-enable protection circuit" * Article entier * | 1,2 | |

DOMAINES TECHNIQUES RECHERCHES (Int. Cl.5)

G 06 F 13

Le présent rapport a été établi pour toutes les revendications

| Lieu de la recherche | Date d'achèvement de la recherche | Examinateur |
|---|---|---|
| LA HAYE | 10-04-1991 | MCDONAGH F.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)